# EUROPÄISCHE PATENTANMELDUNG

(11) **EP 0 817 265 A1**
(43) Veröffentlichungstag der Anmeldung: **07.01.1998**
(21) Anmeldenummer: 97110219.9
(22) Anmeldetag: 23.06.1997
(51) Int. Cl.: H01L 23/495

(54) **Zuleitungsrahmen für einen integrierten Schaltkreis und ein einen Zuteilungsrahmen enthaltendes Bauteil mit Kühlkörper**

(30) Priorität: 28.06.1996 DE 19626088
(71) Anmelder: SIEMENS AKTIENGESELLSCHAFT, 80333 München (DE)
(72) Erfinder: Luckner, Hans-Uwe, Dipl.-Ing. (FH), 93049 Regensburg (DE); Huska, Rochus, Dipl.-Ing. (FH), Verstorben (DE)

(57) **Zusammenfassung**

In einem Zuleitungsrahmen (1) für einen integrierten Schaltkreis sind Befestigungselemente (7) vorgesehen, die zweifach abgewinkelt sind und dadurch einen parallel versetzten Endbereich (18) aufweisen, an dem mittels Schweißpunktbefestigung ein Kühlkörper (6) befestigt wird. Dadurch wird bei gleicher Fläche eine größere Anzahl von freien aktiven Anschlußfingern (4) erreicht.

## Beschreibung

Die Erfindung betrifft einen Zuleitungsrahmen zur Verwendung in einem Leistungsgehäuse mit Anschlußfingern und Befestigungsmitteln. Weiterhin betrifft die Erfindung ein Bauteil zur Verwendung in einem Leistungsgehäuse für einen integrierten Schaltkreis mit einem Heatslug und einem Zuleitungsrahmen, der Anschlußfinger und Befestigungsmittel zur Verbindung mit dem Heatslug aufweist.

Solche Zuleitungsrahmen, die auch als Leadframe bezeichnet werden, werden in Leistungsgehäusen für integrierte Schaltkreise üblicherweise in Kombination mit einem Heatslug verwendet, der in der Regel aus einem metallischen Block besteht und zu einer besseren Verteilung der Wärme im Gehäuse und damit einer besseren Wärmeabfuhr dient.

Es ist bekannt, den Heatslug mit vier elektrischen Anschlüssen des Leadframes, die auch als Pins bezeichnet werden, am Leadframe zu befestigen. Diese Anschlüsse stehen dann für eine elektrische Kontaktierung nicht mehr zur Verfügung.

Der Erfindung liegt die **Aufgabe** zugrunde, einen Zuleitungsrahmen und ein Bauteil der eingangs genannten Art zu schaffen, welche einfach herstellbar sind und eine möglichst gute Flächenausnutzung erlauben.

Zur Lösung dieser Aufgabe wird der eingangs genannte Zuleitungsrahmen so ausgebildet, daß die Befestigungsmittel zweifach abgewinkelte Befestigungselemente aufweisen, so daß ein Endbereich der Befestigungselemente gegenüber dem Zuleitungsrahmen parallel versetzt ist, die Endbereiche der Befestigungselemente zur Herstellung einer Verbindung flächig ausgebildet sind und eines der Befestigungselemente elektrisch leitend mit einem der Anschlußfinger verbunden ist.

Das eingangs genannte Bauteil, welches einen Heatslug und einen Zuleitungsrahmen aufweist, wird zur Lösung der Aufgabe so weiter entwickelt, daß die Befestigungsmittel zweifach abgewinkelte Befestigungselemente aufweisen, ein Endbereich der Befestigungselemente gegenüber dem Zuleitungsrahmen parallel versetzt ist, die Endbereiche der Befestigungselemente zur Verbindung mit dem Heatslug flächig ausgebildet sind und eines der Befestigungselemente elektrisch leitend mit einem der Anschlußfinger verbunden ist, wobei dieser Anschlußfinger einen Masseanschluß für den Heatslug darstellt.

Durch diese Maßnahmen ergeben sich die Vorteile, daß der Heatslug mit einem gewissen Versatz oder Abstand gegenüber den Anschlußfingern des Zuleitungsrahmens angeordnet werden kann und die Anschlußfinger dadurch näher an Kontaktflächen an einer Oberseite eines integrierten Schaltkreises, positioniert werden können. Die flächigen Endbereiche der Befestigungselemente spannen eine Ebene auf, die parallel versetzt zu der Ebene des Zuleitungsrahmens liegt. In dieser Ebene erfolgt die Befestigung des Heatslugs. Auf dem Heatslug und damit auch in dieser Ebene erfolgt die Befestigung des integrierten Schaltkreises. Durch die Verwendung dieser zusätzlichen Befestigungselemente steht bei gleicher Gehäusegröße eine größere Anzahl von elektrisch aktiven Anschlußfingern oder Pins zum Anschluß an den integrierten Schaltkreis zur Verfügung.

In einer bevorzugten Ausführungsform sind vier Befestigungselemente vorgesehen. Eine stabile Befestigung ist auch mit drei Befestigungselementen oder mehr als vier Befestigungselementen denkbar. Besonders günstig ist jedoch die Anordnung von vier Befestigungselementen in den Ecken des Zuleitungsrahmens.

Die zweifach abgewinkelten Befestigungselemente sind in einer Weiterbildung Z-förmig ausgebildet. In einer anderen Ausführungsform sind die direkten Übergänge der zweifach abgewinkelten Befestigungselemente abgerundet ausgebildet, um keinen echten Knick zu erzeugen und Materialbruch zu vermeiden. Die flächig ausgebildeten Endbereiche der Befestigungselemente sind bevorzugt zur Schweißpunktbefestigung ausgelegt. Denkbar ist auch eine Niet-, Kleb- oder Lötbefestigung.

In einer besonders bevorzugten Ausführungsform weist der Zuleitungsrahmen zwei sich gegenüberliegende Reihen von Anschlußfingern auf, wobei die Befestigungselemente an den beiden anderen sich gegenüberliegenden Seiten des Zuleitungsrahmens befestigt sind. Eine solche Anordnung wird insbesondere bei einem DSO(Dual Small Outline)-Leistungsgehäuse verwirklicht. Bevorzugt sind die Befestigungselemente dabei an einer Bruchkante des Zuleitungsrahmens ausgebildet, so daß nach Eingießen des Zuleitungsrahmens und des integrierten Schaltkreises in ein Preßmassengehäuse die überstehenden Bereiche des Zuleitungsrahmens problemlos abgebrochen werden können. Der Zuleitungsrahmen ist bevorzugt zur Verwendung in einem DSO-Gehäuse ausgebildet.

In einer anderen Weiterbildung weist der Heatslug Vorsprünge auf, die in ihren Abmessungen den flächigen Endbereichen der Befestigungselemente entsprechen. Günstigerweise sind vier solcher Vorsprünge jeweils in den Ecken des Heatslugs angeordnet. Der Vorsprung ist dabei günstigerweise einstückig mit dem Heatslug ausgebildet, aber nicht so dick wie dieser, so daß der Vorsprung eine obere Kante oder oberen Vorsprung des Heatslugs darstellt.

Nachfolgend wird die Erfindung anhand eines in der Zeichnung dargestellten Ausführungsbeispiels weiter erläutert. Im einzelnen zeigen die schematischen Darstellungen in:
- Fig. 1: eine Draufsicht auf ein erfindungsgemäßes Leadframe;
- Fig. 2: einen Querschnitt entlang der Linie A-A des erfindungsgemäßen Leadframes;
- Fig. 3: einen Querschnitt entlang der Linie B-B des erfindungsgemäßen Leadframes;
- Fig. 4: eine seitliche Detailansicht eines Befestigungselements und
- Fig. 5: eine Draufsicht auf das Befestigungselement gemäß Fig. 4.

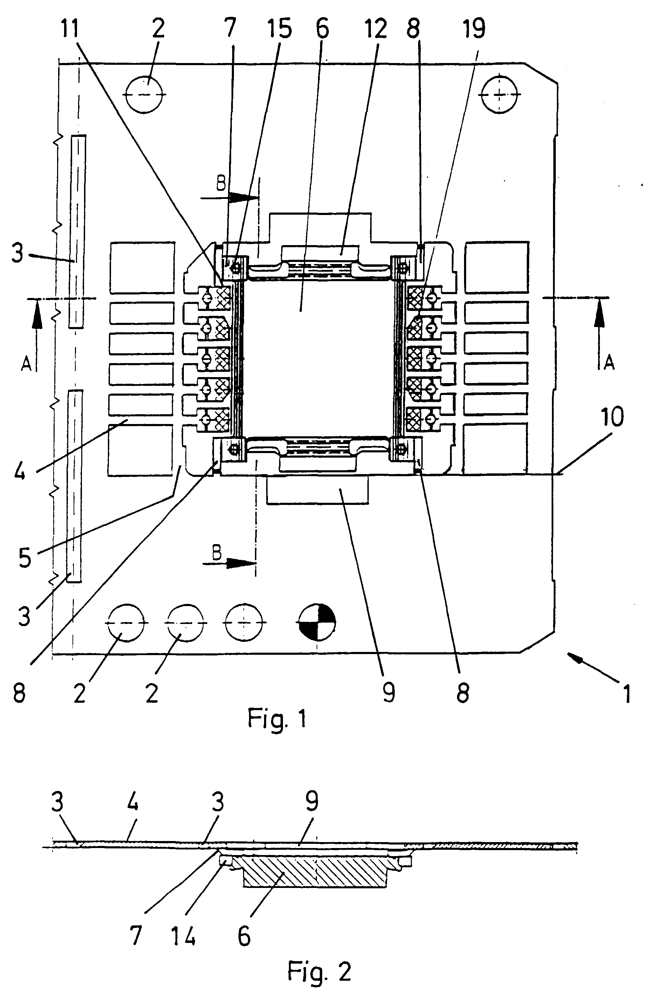

In Fig. 1 ist ein erfindungsgemäßer Zuleitungsrahmen dargestellt, der insgesamt mit 1 bezeichnet ist. Ein solcher Zuleitungsrahmen ist Bestandteil eines Streifens, der üblicherweise aus zehn einzelnen Zuleitungsrahmen 1 besteht. Der Zuleitungsrahmen 1 weist im Außenbereich verschiedene kreisförmige Ausnehmungen 2 auf, die zum automatisierten Weitertransport des gesamten Streifens mit der Vielzahl von Zuleitungsrahmen 1 dienen. Die länglichen Ausnehmungen 3 dienen als Sollbruchstelle zum Trennen der einzelnen Zuleitungsrahmen 1 aus dem Gesamtstreifen. Der Zuleitungsrahmen 1 weist zwei Reihen von jeweils fünf Anschlußfingern auf, die sich gegenüberliegen. Die Anschlußfinger sind mit 4 bezeichnet. Die Stabilität der Anschlußfinger 4 wird durch einen Verbindungssteg 5, der jeweils eine Reihe von Anschlußfingern verbindet, erhöht. Der Verbindungssteg 5 wird nach dem Einpressen in ein Preßmassengehäuse entfernt. Im vorderen Bereich weisen die Anschlußfinger 4 eine Silberbeschichtung 19 auf, so daß eine bessere Kontaktherstellung bei der Bondverbindung der Anschlußfinger 4 mit einem Halbleiterchip ermöglicht wird. Zentral zwischen den Anschlußfingern 4 ist ein Heatslug 6 angeordnet, der gegenüber dem Zuleitungsrahmen 1 etwas abgesenkt ist. Der Heatslug 6 wird von vier Befestigungselementen 7 gehalten, die eine Anschlußbefestigung 8 zum Zuleitungsrahmen 1 aufweisen. In diesem Bereich ist eine weitere Ausnehmung 9 vorgesehen, so daß eine gestrichelt dargestellte Bruchkante 10 entsteht, an der nach dem Eingießen eines integrierten Schaltkreises der äußere Bereich des Zuleitungsrahmens 1 abgetrennt werden kann. Eines der Befestigungselemente 7, in diesem Fall das links oben dargestellte, weist eine elektrische Verbindung 11 auf, die einstückig mit der Anschlußbefestigung 8 ausgebildet ist und den nächstgelegenen Anschlußfinger 4 kontaktiert. Auf diese Weise wird ein Anschlußfinger 4 als Masseanschluß für den Heatslug 6 ausgebildet. Der Heatslug 6 ist von rechteckiger Form und weist an den beiden Stirnseiten Erweiterungen 12 auf.

In Fig. 2 ist ein Schnitt entlang der Linie A-A aus Fig. 1 dargestellt, der durch einen der Anschlußfinger 4 verläuft. Der Schnitt durch den Anschlußfinger wird von der länglichen Ausnehmung 3 und dem Loch 13 unterbrochen. Im zentralen Bereich des Zuleitungsrahmens ist die Kontur der Ausnehmung 9 angedeutet. Der Heatslug 6 befindet sich mit einem gewissen Abstand, auch Downset genannt, vom Zuleitungsrahmen entfernt. Der Heatslug 6 weist an den Ecken Vorsprünge 14 auf, die mit dem Befestigungselement 7 verbunden sind. Die Vorsprünge 14 sind nur über einen Bruchteil der Tiefe des Heatslug 6 ausgebildet. Die Befestigungselemente 7 sind an den Vorsprüngen 14 durch Schweißpunkte 15 verbunden, die auch in Fig. 1 dargestellt sind. Diese Schweißpunkte werden mit einem Laser erzeugt.

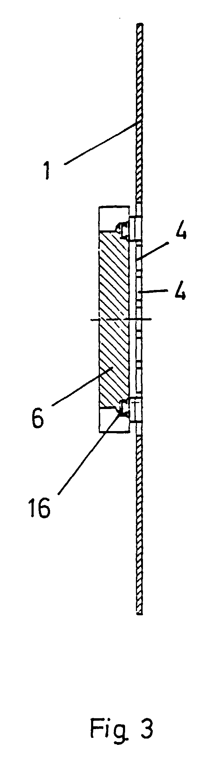

In Fig. 3 ist ein Schnitt entlang der Linie B-B in Fig. 1 dargestellt. Neben dem Zuleitungsrahmen 1 sind im zentralen Bereich die Anschlußfinger 4 dargestellt und im Heatslug 6 ist eine Kerbe 16 vorgesehen, mit der eine zusätzliche Verankerung des Heatslugs beim Einpressen des Gehäuses erreicht wird.

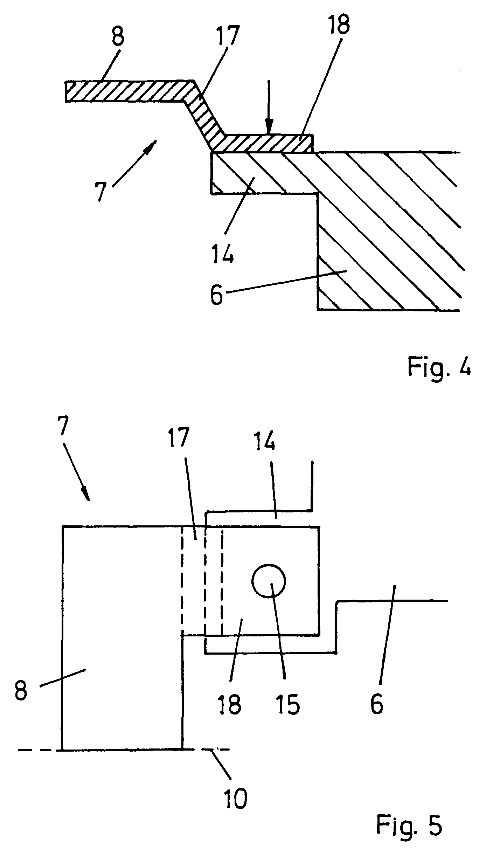

In den Fig. 4 und 5 sind ein Querschnitt und eine Draufsicht auf ein Befestigungselement 7 und den dazugehörigen Teil eines Heatslug 6 dargestellt. Das Befestigungselement 7 weist eine Anschlußbefestigung 8 auf, die in der Ebene des gesamten Zuleitungsrahmens 1 ausgebildet ist, einen Verbindungsteil 17 und einen flächig erweiterten Endbereich 18 auf. Dieser flächig erweiterte Endbereich 18 ist parallel versetzt zum Zuleitungsrahmen ausgebildet und mit einem Schweißpunkt 15 auf dem Vorsprung 14 des Heatslug 6 angeordnet, wobei der Vorsprung 14 den Eckbereich des Heatslug 6 quadratisch erweitert und in seiner Form der flächigen Erweiterung des Endbereichs 18 des Befestigungselements 7 entspricht. Um einen parallelen Versatz zwischen Anschlußbefestigung 8 und Endbereich 18 zu erreichen, ist das Verbindungsteil mit zwei Abwinklungen ausgebildet, durch die ein insgesamt Z-förmiges Befestigungselement entsteht, welches einstückig ausgebildet sein. Die Abwinklungen können zur Materialschonung auch abgerundet ausgebildet ist. Am Ende der Anschlußbefestigung 8 befindet sich die Bruchkante 10.

### Bezugszeichenliste

- 1: Zuleitungsrahmen
- 2: kreisförmige Ausnehmungen
- 3: längliche Ausnehmungen
- 4: Anschlußfinger
- 5: Verbindungssteg
- 6: Heatslug
- 7: Befestigungselement
- 8: Anschlußbefestigung
- 9: Ausnehmung
- 10: Bruchkante
- 11: elektrische Verbindung
- 12: Erweiterung
- 13: Loch
- 14: Vorsprung
- 15: Schweißpunkt
- 16: Kerbe
- 17: Verbindungsteil
- 18: Endbereich
- 19: Silberbeschichtung

## Patentansprüche

1. Zuleitungsrahmen zur Verwendung in einem Leistungsgehäuse mit Anschlußfingern (4) und Befestigungsmitteln,
**dadurch gekennzeichnet**,
daß die Befestigungsmittel zweifach abgewinkelte Befestigungselemente (7) aufweisen, so daß ein Endbereich (18) der Befestigungselemente (7) gegenüber dem Zuleitungsrahmen (1) parallel versetzt ist,
daß die Endbereiche (18) der Befestigungselemente (7) zur Herstellung einer festen Verbindung ausgebildet sind und daß eines der Befestigungselemente (7) elektrisch leitend mit einem der Anschlußfinger (4) verbunden ist.

2. Zuleitungsrahmen nach Anspruch 1,
**dadurch gekennzeichnet,**
daß vier Befestigungselemente (7) vorgesehen sind.

3. Zuleitungsrahmen nach einem der Ansprüche 1 oder 2,
**dadurch gekennzeichnet,**
daß die Befestigungselemente (7) in Eckbereichen des Zuleitungsrahmens (1) angeordnet sind.

4. Zuleitungsrahmen nach einem der Ansprüche 1 oder 2,
**dadurch gekennzeichnet,**
daß die Befestigungselemente (7) Z-förmig ausgebildet sind.

5. Zuleitungsrahmen nach einem der vorhergehenden Ansprüche,
**dadurch gekennzeichnet,**
daß die flächig ausgebildeten Endbereiche (18) der Befestigungselemente (7) zur Schweißpunktbefestigung ausgelegt sind.

6. Zuleitungsrahmen nach einem der vorhergehenden Ansprüche,
**dadurch gekennzeichnet**,
daß der Zuleitungsrahmen (1) zwei sich gegenüberliegende Reihen von Anschlußfingern (4) aufweist und die Befestigungselemente (7) an den beiden anderen sich gegenüberliegenden Seiten des Zuleitungsrahmens (1) befestigt sind.

7. Zuleitungsrahmen nach einem der vorhergehenden Ansprüche,
**dadurch gekennzeichnet**,
daß die Befestigungselemente (7) an einer Bruchkante (10) des Zuleitungsrahmens (1) ausgebildet sind.

8. Zuleitungsrahmen nach einem der vorhergehenden Ansprüche,
**dadurch gekennzeichnet**,
daß die zweifach abgewinkelten Befestigungselemente (7) abgerundet ausgebildet sind.

9. Zuleitungsrahmen nach einem der vorhergehenden Ansprüche,
**dadurch gekennzeichnet**,
daß der Zuleitungsrahmen (1) zur Verwendung in einem DSO-Gehäuse ausgebildet ist.

10. Bauteil zur Verwendung in einem Leistungsgehäuse für einen integrierten Schaltkreis mit einem Heatslug (6) und einem Zuleitungsrahmen nach einem der Ansprüche 1 bis 9, der Befestigungsmittel zur Verbindung mit dem Heatslug (6) aufweist,
**dadurch gekennzeichnet**,
daß die Endbereiche der Befestigungselemente zur Verbindung mit dem Heatslug (6) flächig ausgebildet sind, und
daß eines der Befestigungselemente (7) elektrisch leitend mit einem Anschlußfinger (4) verbunden ist, wobei dieser Anschlußfinger einen Masseanschluß für den Heatslug (6) darstellt.

11. Bauteil nach Anspruch 10,
**dadurch gekennzeichnet**,
daß der Heatslug (6) Vorsprünge (14) aufweist, die in ihren Abmessungen den flächigen Endbereichen (18) der Befestigungselemente (7) entsprechen.

12. Bauteil nach einem der Ansprüche 10 oder 11,
**dadurch gekennzeichnet**,
daß die Vorsprünge (14) des Heatslugs (6) in den vier Ecken angeordnet sind.
